# EUROPEAN PATENT APPLICATION

(11) **EP 3 780 931 A1**
(43) Date of publication of application: **17.02.2021**
(21) Application number: 18912772.3
(22) Date of filing: 30.03.2018
(51) Int. Cl.: H05K 13/04

(54) **MOUNTING HEAD**

(71) Applicant: Fuji Corporation, Chiryu-shi, Aichi 472-8686 (JP)
(72) Inventor: IMURA Jinya, Chiryu-shi, Aichi 472-8686 (JP)
(74) Representative: Grünecker Patent- und Rechtsanwälte PartG mbB
(86) International application number: PCT/JP2018/013949
(87) International publication number: WO 2019/187144

(57) **Abstract**

A mounting head main body includes a first suction nozzle and a second suction nozzle which are configured to pick up a component by negative pressure air, a head main body detachably attached to a moving table of a component mounter and configured to hold the first suction nozzle and the second suction nozzle, a first air passage configured to communicate with a first supply passage provided in the moving table with the head main body attached to the moving table, and cause negative pressure air supplied via the first supply passage to flow into the first suction nozzle, and a second air passage configured to communicate with a second supply passage provided in the moving table with the head main body attached to the moving table, and cause negative pressure air supplied via the second supply passage to flow into the second suction nozzle.

## Description

### Technical Field

The present invention relates to a mounting head.

### Background Art

A mounting head configures a component mounter for mounting components on circuit boards and is used for a mounting process performed by the component mounter. The mounting head holds multiple suction nozzles for picking up a component using negative pressure air. Patent Literature 1 discloses a mounting head for detachably holding 12 suction nozzles. This mounting head is configured so that an air passage is branched in an interior of a head main body in such a manner that negative pressure air supplied from an air supply source provided outside the mounting head is distributed into the 12 suction nozzles.

### Patent Literature

Patent Literature 1: JP-A-2006-261325

### Summary of the Invention

### Technical Problem

In a mounting process using the mounting head described above, for example, in the event that one of the multiple suction nozzles fails to pick up a component, a leakage of negative pressure air occurs. When the leakage of negative pressure air affects the suction force of the other suction nozzle, the component is caused to deviate from its proper position with respect to the suction nozzle, as a result of the suction nozzle being moved while holding the component with its suction force, which turns out a deterioration in accuracy of the mounting process.

An object of the present description is to provide a mounting head which can reduce a risk of a suction force of another suction nozzle being affected by the leakage of negative pressure air, and thereby maintains the accuracy of a mounting process to be performed.

### Solution to Problem

The present description discloses a first mounting head main body including a first suction nozzle and a second suction nozzle which are configured to pick up a component by negative pressure air, a head main body detachably attached to a moving table of a component mounter and configured to hold the first suction nozzle and the second suction nozzle, a first air passage configured to communicate with a first supply passage provided in the moving table with the head main body attached to the moving table, and cause negative pressure air supplied via the first supply passage to flow into the first suction nozzle, and a second air passage configured to communicate with a second supply passage provided in the moving table with the head main body attached to the moving table, and cause negative pressure air supplied via the second supply passage to flow into the second suction nozzle.

The present specification discloses a second mounting head including:
a first suction nozzle and a second suction nozzle which are configured to pick up a component by negative pressure air;
a head main body configured to hold the first suction nozzle and the second suction nozzle;
a first air passage configured to cause negative pressure air supplied thereto to flow into the first suction nozzle;
a second air passage configured to cause negative pressure air supplied thereto to flow into the second suction nozzle; and
a valve device configured to switch states of first air passage and the second air passage between a state in which the first air passage and the second air passage form negative pressure air supply systems which differ from each other and a state in which the first air passage and the second air passage form a same negative pressure air supply system.

### Advantageous Effects of the Invention

According to the configuration of the first mounting head, the first air passage causing negative pressure air to flow into the first suction nozzle and the second air passage causing negative pressure air to flow into the second suction nozzle are independent of each other in the interior of the head main body. That is, the first air passage and the second air passage do not communicate with each other in the interior of the head main body and are separately coupled to the first suction nozzle and the second suction nozzle, respectively, at a boundary section between the moving table and the head main body. As a result, the first air passage and the second air passage form the negative pressure air supply systems, which differ from each other, in the interior of the head main body. Therefore, in the event that a leakage of negative pressure air occurs in one of the suction nozzles, a risk of the suction force of the other suction nozzle being affected can be reduced. As a result, the accuracy of a mounting process can be maintained.

According to the configuration of the second mounting head, the first air passage causing negative pressure air to flow into the first suction nozzle and the second air passage causing negative pressure air to flow into the second suction nozzle are switched by the valve device between the state in which the different negative pressure air supply systems are formed and the state in which the same negative pressure air supply system is formed. Therefore, in the event that a leakage of negative pressure air occurs in one of the suction nozzles, a risk of the suction force of the other suction nozzle being affected can be reduced as a result of the different supply systems being formed. As a result, the accuracy of a mounting process can be maintained.

### Brief Description of Drawings

[Fig. 1] Fig. 1 is a plan view showing a configuration of a component mounter including a mounting head according to an embodiment of the present invention.
[Fig. 2] Fig. 2 is a side view showing the mounting head shown in Fig. 1.
[Fig. 3] Fig. 3 is a circuit diagram showing a first mode of an air supply circuit formed in the mounting head.
[Fig. 4] Fig. 4 is a circuit diagram showing a second form of an air supply circuit formed in the mounting head.
[Fig. 5a] Fig. 5a is a circuit diagram showing a third mode of an air supply circuit formed in the mounting head illustrating a state in which a single supply system is formed.
[Fig. 5b] Fig. 5b is a circuit diagram showing the third mode of an air supply circuit formed in the mounting head illustrating a state in which two supply systems are formed.

### Description of Embodiment

### 1. Configuration of Component Mounter 10

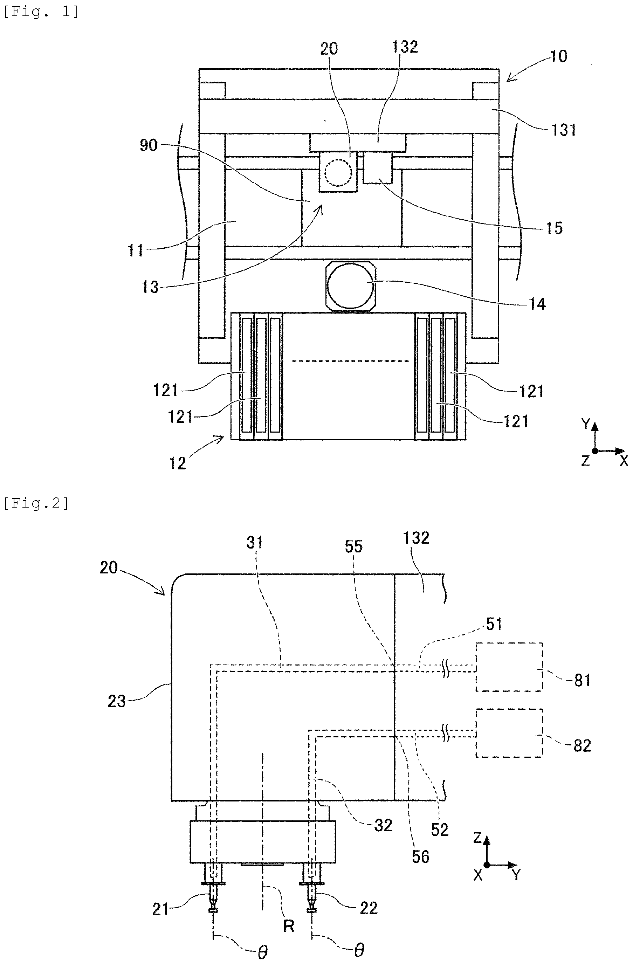

Component mounter 10 includes, as shown in Fig. 1, board conveyance device 11, component supply device 12, component transfer device 13, part camera 14, and board camera 15. Board conveyance device 11 is made up of a belt conveyor or the like. Board conveyance device 11 conveys subsequently board 90 in a conveyance direction and positions board 90 in a predetermined position in an interior of component mounter 10. Board conveyance device 11 conveys out or unloads board 90 from the interior to an exterior of component mounter 10 after a mounting process of components by component mounter 10 is finished.

Component supply device 12 supplies components to be mounted on board 90. Component supply device 12 includes feeders 121 which are set in such a manner as to be aligned in an X-axis direction. Feeder 121 feeds and moves a carrier tape in which a number of components are accommodated so that the components are supplied to be picked up in a supply position situated at a distal end side of feeder 121.

Component transfer device 13 transfers a component supplied by component supply device 12 to a predetermined mounting position on board 90 which is conveyed in or loaded in the interior of component mounter 10 by board conveyance device 11. Head driving device 131 of component transfer device 13 moves moving table 132 in a horizontal direction (the X-axis direction, a Y-axis direction) with a linear motion mechanism. Mounting head 20 is fixed to moving table 132 with a clamp member, not shown, in such a manner as to be exchanged.

One or multiple holding members are detachably provided on mounting head 20. For example, a suction nozzle, which is configured to be supplied with negative pressure air so as to pick up a component, a chuck for clamping a component, and the like can be adopted as the holding member. In the present embodiment, as shown in Fig. 2, mounting head 20 supports two suction nozzles 21, 22 in such a manner as not only to move in a Z-axis direction but also to rotate around a θ-axis, which is parallel to the Z-axis. A detailed configuration of mounting head 20 will be described later on.

Part camera 14 and board camera 15 are a digital imaging device having an imaging element such as a CMOS or the like. Part camera 14 and board camera 15 execute imaging based on a control signal and transmit image data obtained through the imaging. Part camera 14 is fixed to a base plate of component mounter 10 in such a manner that an optical axis thereof is directed upwards in the Z-axis direction. Part camera 14 is configured to image components held by two suction nozzles 21, 22 from below. Board camera 15 is configured to image board 90 from above.

Component mounter 10 executes a mounting process of mounting components on board 90. The mounting process include a process of repeating multiple times a pick-and-place cycle (hereinafter, referred to as a "PP cycle") in which a component supplied by component supply device 12 is picked up and the component so picked up is mounted in a predetermined position on board 90. In the mounting process, component mounter 10 controls the operation of component transfer device 13 based on information outputted from various types of sensors, the results of an image processing, a control program stored in advance, and the like. As a result, positions and angles of two suction nozzles 21, 22 supported by mounting head 20 are controlled.

### 2. Detailed Configuration of Mounting Head 20

As shown in Fig. 2, mounting head 20 includes two suction nozzles 21, 22 (hereinafter, referred to as "first suction nozzle 21" and "second suction nozzle 22") for picking up a component by means of negative pressure air. First suction nozzle 21 and second suction nozzle 22 are detachably held to head main body 23. Head main body 23 is detachably clamped to moving table 132.

First air passage 31 and second air passage 32 are formed in head main body 23. First air passage 31 communicates with first supply passage 51 provided in moving table 132 with head main body 23 attached to moving table 132. More specifically speaking, when head main body 23 is clamped to moving table 132, first air passage 31 is connected to first supply passage 51 at first connecting section 55. As a result, first air passage 31 causes negative pressure air supplied via first supply passage 51 to flow into first suction nozzle 21.

Second air passage 32 communicates with second supply passage 52 provided in moving table 132 with head main body 23 attached to moving table 132. More specifically speaking, when head main body 23 is clamped to moving table 132, second air passage 32 is connected to second supply passage 52 at second connecting section 56. As a result, second air passage 32 causes negative pressure air supplied via second supply passage 52 to flow into second suction nozzle 22.

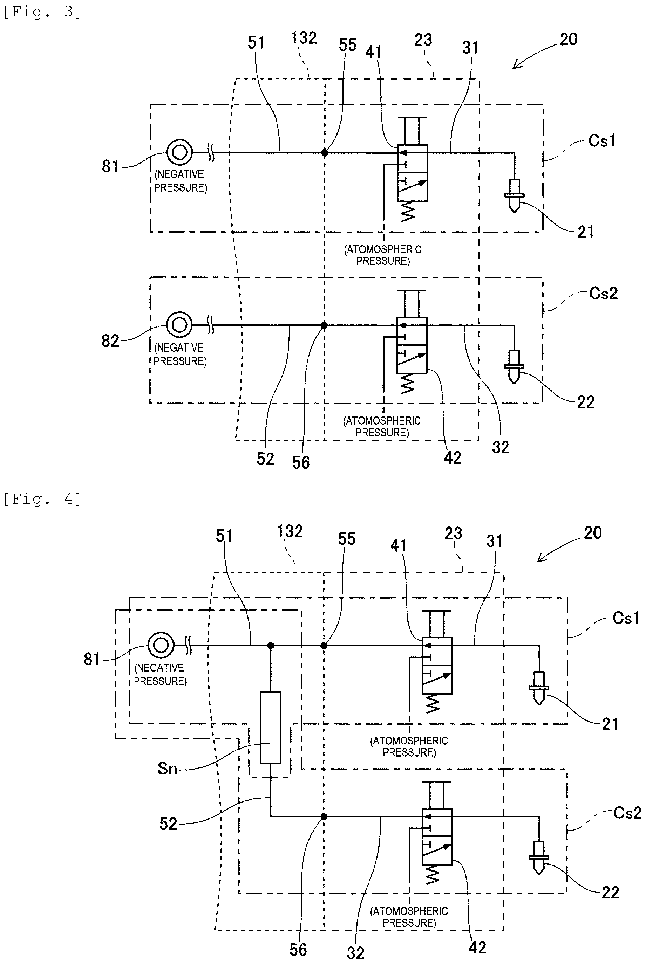

First air passage 31 and second air passage 32 do not communicate with each other and are kept in a state in which they are independent of each other in an interior of head main body 23. In other words, first air passage 31 and second air passage 32 form negative pressure air supply systems which differ from each other. In order to form multiple supply systems, various forms can be adopted, in addition to a mode in which multiple air supply sources are provided (refer to Figs. 2 and 3). Details of the negative pressure air supply systems will be described later on.

Additionally, component mounter 10 includes one or multiple air supply sources. Fig. 2 shows a mode in which component mounter 10 includes two air supply sources (hereinafter, referred to as "first air supply source 81" and "second air supply source 82"). First air supply source 81 and second air supply source 82 supply negative pressure air in the same or different supply systems. First air supply source 81 and second air supply source 82 are made up of, for example, an air pump provided inside or outside component mounter 10.

Here, as shown in Fig. 3, first negative pressure valve 41 is provided in first air passage 31. First negative pressure valve 41 switches states of first air passage 31 between a state in which negative pressure air is allowed to flow and a state in which the flow of negative pressure air is cut off. First negative pressure valve 41 is a three-port, two-position solenoid valve in the present embodiment. First negative pressure valve 41 is put into an open state when a solenoid is energized by been fed to thereby cause negative pressure air to flow through first air passage 31. When first air passage 31 allows negative pressure air to flow therethrough, first suction nozzle 21 is supplied with negative pressure air to thereby be enabled to hold a component.

One of three ports of first negative pressure valve 41 normally communicates with the atmosphere. First negative pressure valve 41 is put into a closed state by means of an elastic force of an elastic member when feeding to the solenoid is cut off, thereby releasing first air passage 31 to the atmosphere. When first air passage 31 is released to the atmosphere, first suction nozzle 21 is caused to communicate with the atmosphere, resulting in a state in which first suction nozzle 21 releases the component held thereby.

Similarly, second negative pressure valve 42 is provided in second air passage 32. Since second negative pressure valve 42 has a substantially similar configuration to that of first negative pressure valve 41, a detailed description thereof will be omitted. In response to a command inputted thereinto from a control device of component mounter 10, mounting head 20 controls the operations of first negative pressure valve 41 and second negative pressure valve 42.

### 3. Configuration of Negative Pressure Air Supply System

Component mounter 10, which includes mounting head 20 configured as described above, first causes first suction nozzle 21 and second suction nozzle 22 to pick up subsequently a component and thereafter causes them to mount subsequently the component so picked up in predetermined mounting positions on board 90 in a PP cycle in a mounting process. In the PP cycle described above, a pickup error, in which the suction nozzles cannot pick up a component normally, can be caused due to a mechanical factor or a variation in mounting environment.

In the event that a pickup error as descried above is caused, negative pressure air leaks from the suction nozzle in which the leakage of negative pressure air is caused, whereby an air pressure in an air passage extending from the suction nozzle to the air supply source is increased. As this occurs, with the mounting head including the multiple suction nozzles, there is a possibility that the leakage of negative pressure air that occurs in one suction nozzle calls for a decrease in the suction force of the other suction nozzle. The decrease in the suction force of the suction nozzle can constitute a factor triggering a positional deviation of a component with respect to the suction nozzle.

Then, with mounting head 20 of the present embodiment, in the event that a leakage of negative pressure air occurs in one of first suction nozzle 21 and second suction nozzle 22, multiple negative pressure air supply systems are formed so that a sufficient suction force is secured in the other suction nozzle. Hereinafter, individual modes of air supply circuits formed in mounting head 20 will be described. An air supply circuit of mounting head 20 include one or multiple supply systems.

### 3-1. First Mode of Air Supply Circuit

In a first mode, first air passage 31 and second air passage 32 are coupled individually to different air supply sources (first air supply source 81 and second air supply source 82) as shown in Fig. 3 to thereby form negative pressure air supply systems which differ from each other. First air passage 31 is connected to first supply passage 51 provided in moving table 132 at first connecting section 55 when mounting head 20 is attached to moving table 132. Similarly, second air passage 32 is connected to second supply passage 52 provided in moving table 132 at second connecting section 56 when mounting head 20 is attached to second moving table 132.

In the first mode, first supply system Cs1 is made up of first suction nozzle 21, first air passage 31, first negative pressure valve 41, first supply passage 51, and first air supply source 81. Second supply system Cs2 includes second suction nozzle 22, second air passage 32, second negative pressure valve 42, second supply passage 52, and second air supply source 82. As described above, first supply system Cs1 and second supply system Cs2 are completely independent of each other, so that even in the event that a leakage of negative pressure air occurs in one of the first and second supply systems Cs1, Cs2, the other is prevented from being affected by the leakage of negative pressure air.

### 3-2. Second Mode of Air Supply Circuit

In a second mode, first air passage 31 and second air passage 32 are both coupled single same first air supply source 81 as shown in Fig. 4. First air passage 31 is connected with first supply passage 51 provided in moving table 132 at first connecting section 55 when mounting head 20 is attached to moving table 132. Similarly, second air passage 32 is connected to second supply passage 52 provided in moving table 132 at second connecting section 56 when mounting head 20 is attached to second moving table 132.

First supply passage 51 and second supply passage 52 communicate with each other outside head main body 23 and inside moving table 132. First supply passage 51 and second supply passage 52 are coupled to single and same first air supply source 81. As a result, negative pressure air is supplied to first air passage 31 and second air passage 32 via first supply passage 51 and second supply passage 52, respectively, by first air supply source 81.

Here, in the second mode, first air passage 31 and second air passage 32 form negative pressure air supply systems which differ from each other as a result of an overall volume into which volumes of first air passage 31, second air passage 32, first supply passage 51, and second supply passage 52 are integrated being secured to a predetermined value or more. Here, in order to secure the overall volume to the predetermined value or more, for example, a sectional area of first air passage 31 needs to be formed large over a predetermined length. This will also be true with second air passage 32, first supply passage 51, and second supply passage 52.

In the second mode, pressure accumulation chamber Sn is provided in second supply passage 52. As a result, the overall volume, into which the volumes of first air passage 31, second air passage 32, first supply passage 51, and second supply passage 52, which communicate with each other, are integrated, is secured to the predetermined value or more. In this way, when the overall volume is secured to the predetermined value or more, a degree at which a variation in flow state of negative pressure air in one supply system affects a flow state of negative pressure air in the other supply system is decreased to a small lever by the action of pressure accumulation chamber Sn. As a result, the multiple supply systems are formed which use pressure accumulation chamber Sn commonly in a shared fashion.

Specifically speaking, first supply system Cs1 is made up of first suction nozzle 21, first air passage 31, first negative pressure valve 41, pressure accumulation chamber Sn, first supply passage 51, and first air supply source 81. Second supply system Cs2 is made up of second suction nozzle 22, second air passage 32, second negative pressure valve 42, pressure accumulation chamber Sn, first supply passage 51, second supply passage 52, and first air supply source 81. As described above, first supply system Cs1 and second supply system Cs2 are independent of each other, providing the configuration in which even in the event that a leakage of negative pressure air occurs in one of first supply system Cs1 and second supply system Cs2, the other is prevented from being affected by the leakage of negative pressure air.

First air passage 31 and second air passage 32 form the different supply systems as a result of the overall volume being secured to the predetermined value or more as described above. Therefore, pressure accumulation chamber Sn can be arranged as required, provided that pressure accumulation chamber Sn is arranged somewhere from first negative pressure value 41 to first air supply source 81 or somewhere from second negative pressure valve 42 to first air supply source 81. Thus, a configuration may be adopted in which pressure accumulation chamber Sn is arranged, for example, in first air passage 31 inside head main body 23.

With the configuration of the present embodiment in which first air passage 31 and second air passage 32 do not communicate with each other inside head main body 23 but are both connected to first supply passage 51 or second supply passage 52, compared with the conventional configuration in which a first air passage and a second air passage communicate with each other inside head main body 23, the overall volume is easy to be secured. That is, in the case that the overall volume is secured to the predetermined value or more, even when pressure accumulation chamber Sn is omitted as described above, the multiple supply system can be formed.

### 3-3. Third Mode of Air Supply Circuit

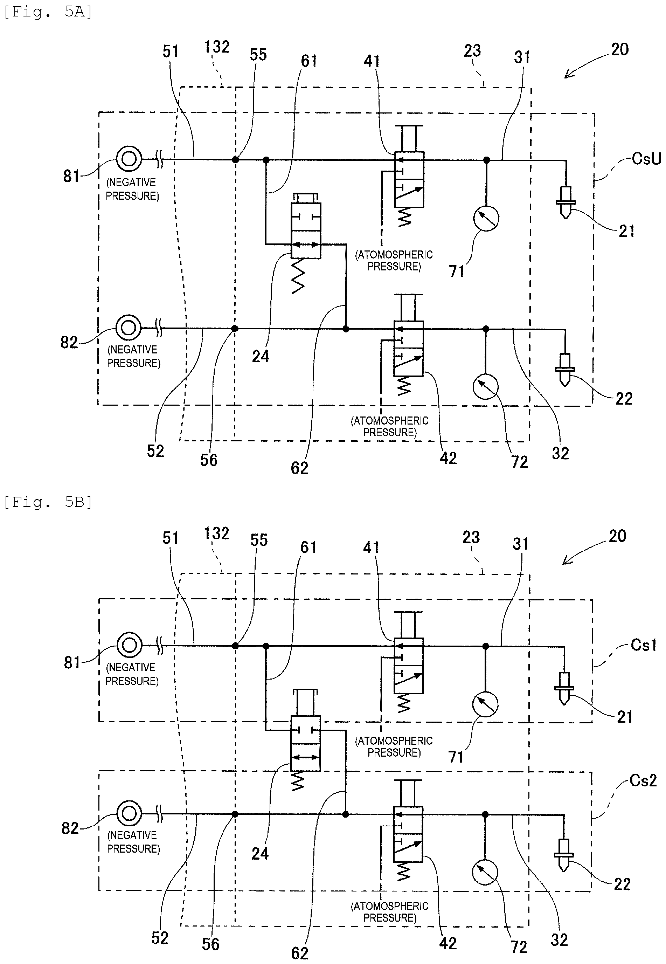

In a third mode, mounting head 20 includes valve device 24 for switching states of first air passage 31 and second air passage 32 between a state in which first air passage 31 and second air passage 32 form supply systems of negative pressure air which differ from each other and a state in which first air passage 31 and second air passage 32 form a single same supply system of negative pressure air, as shown in Fig. 5a. Valve device 24 is, for example, a two-port, two-position solenoid valve.

In the third mode, mounting head 20 includes two air supply sources (first air supply source 81, second air supply source 82), first communication passage 61, second communication passage 62, first detection sensor 71, and second detection sensor 72. First air passage 31 is formed in head main body 23 and is connected with first supply passage 51 at first connecting section 55. First air passage 31 is coupled to first air supply source 81 via first supply passage 51.

Second air passage 32 is formed in head main body 23 and is connected with second supply passage 52 at second connecting section 56. Second air passage 32 is coupled to second air supply source 82 via second supply passage 52. First communication passage 61 couples valve device 24 with first air supply source 81 via first air passage 31 and first supply passage 51 so as to allow negative pressure air to flow from first air supply source 81 to valve device 24. Second communication flow passage 62 couples valve device 24 with second air supply source 82 via second air passage 32 and second supply passage 52 so as to allow negative pressure air to flow from second air supply source 82 to valve device 24.

First detection sensor 71 is provided in first air passage 31. Second detection sensor 72 is provided in second air passage 32. First detection sensor 71 and second detection sensor 72 detect a variation in a flow state of negative pressure air in the corresponding air passages where they are provided. A pressure sensor for detecting an air pressure in first air passage 31 as a flow state of negative pressure air or a flow sensor for detecting an air flow rate in first air passage 31 as a flow state of negative pressure air can be adopted as first detection sensor 71. Similarly, a pressure sensor or a flow sensor can be adopted as second detection sensor 72. Mounting head 20 determines whether a leakage of negative pressure air occurs in first suction nozzle 21 and second suction nozzle 22 based on the results of detections by first detection sensor 71 and second detection sensor 72.

As shown in Fig. 5a, valve device 24 provides a state in which first air passage 31 and second air passage 32 form single same supply system CsU by causing first communication passage 61 to communicate with second communication passage 62. Supply system CsU is made up of first suction nozzle 21, second suction nozzle 22, valve device 24, first air passage 31, second air passage 32, first negative pressure valve 41, second negative pressure valve 42, first supply passage 51, second supply passage 52, first communication passage 61, second communication passage 62, first air supply source 81, and second air supply source 82.

In the event that mounting head 20 determines based on the results of detections by first detection sensor 71 and second detection sensor 72 that a leakage of negative pressure air is occurring, mounting head 20 activates valve device 24. As a result, as shown in Fig. 5b, valve device 24 switches the states of first air passage 31 and second air passage 32 to the state in which first air passage 31 and second air passage 32 form individually the different supply systems by cutting off the communication between first communication passage 61 and second communication passage 62.

Specifically speaking, first supply system Cs1 is made up of first suction nozzle 21, first air passage 31, first negative pressure valve 41, first supply passage 51, and first air supply source 81. Second supply system Cs2 includes second suction nozzle 22, second air passage 32, second negative pressure valve 42, second supply passage 52, and second air supply source 82. As described above, first supply system Cs1 and second supply system Cs2 are completely independent of each other, so that even in the event that a leakage of negative pressure air occurs in one of the first and second supply systems Cs1, Cs2, the other is prevented from being affected by the leakage of negative pressure air.

In the third mode of the air supply circuit, in the case that single same supply system Csu is formed, first suction nozzle 21 and second suction nozzle 22 are supplied with negative pressure air from both first air supply source 81 and second air supply source 82. In contrast with this, in a state (a normal state) in which no leakage of negative pressure air is occurring, mounting head 20 may bring first air supply source 81 or second air supply source 82 to rest.

Specifically speaking, in the normal state, mounting head 20 brings, for example, second air supply source 82 to rest, so that negative pressure air is supplied to first suction nozzle 21 and second suction nozzle 22 by first air supply source 81. As this occurs, a check valve (not shown) is provided between valve device 24 and second air supply source 82, for example, in second supply passage 52, whereby a flow of negative pressure air towards second air supply source 82 is prevented.

Then, in the event that mounting head 20 determines based on the results of detections by first detection sensor 71 and second detection sensor 72 that a leakage of negative pressure air is occurring, mounting head 20 activates second air supply source 82 so as to provide the state in which negative pressure air can be supplied. Thereafter, mounting head 20 activates valve device 24. As a result, as shown in Fig. 5b, valve device 24 provides the state in which first air passage 31 and second air passage 32 form the different supply systems (first supply system Cs1, second supply system Cs2) by cutting off the communication between first communication passage 61 and second communication passage 62.

As shown in the drawing 5a, in the normal state, mounting head 20 forms single supply system CsU by causing first communication passage 61 to communicate with second communication passage 62. As a result of this, in the normal state, a stable supply of negative pressure air in supply system CsU is realized by the operations of first air supply source 81 and second air supply source 82, and a decrease in operational load is realized by bring one of first and second supply sources 81, 82 to rest. In the third mode, a configuration may be adopted in which first air supply source 81 and second air supply source 82 are arranged inside mounting head 20.

### 4. Working Effects Provided by Configuration of Embodiment

In the first mode, the second mode, and the third mode, mounting head 20 described above includes first suction nozzle 21 and second suction nozzle 22 which pick up a component by means of negative pressure air, head main body 23 which is detachably attached to moving table 132 of component mounter 10 and holds first suction nozzle 21 and second suction nozzle 22, first air passage 31 which communicates with first supply passage 51 provided in moving table 132 with head main body 23 attached to moving table 132 to cause negative pressure air supplied via first supply passage 51 to flow into first suction nozzle 21, and
second air passage 32 which communicates with second supply passage 52 provided in moving table 132 with head main body 23 attached to moving table 132 to cause negative pressure air supplied via second supply passage 52 to flow into second suction nozzle 22.

With the configuration described above, first air passage 31 causing negative pressure air to flow into first suction nozzle 21 and second air passage 32 causing negative pressure air to flow into second suction nozzle 22 are kept independent of each other inside head main body 23. That is, first air passage 31 and second air passage 32 do not communicate with each other inside head main body 23, but are separately coupled to the corresponding negative pressure supply sources at the corresponding boundary sections between head main body 23 and moving table 132. As a result, first air passage 31 and second air passage 32 form the negative pressure air supply systems (first supply system Cs1, second supply system Cs2) which differ from each other at least inside head main body 23. Consequently, compared with the conventional mounting head in which the air passage is branched inside the head main body, in the event that a leakage of negative pressure air occurs in one of the suction nozzles, a risk of the suction force of the other suction nozzle being affected can be reduced. As a result, the accuracy of a mounting process can be maintained.

In the third mode, mounting head 20 described above includes first suction nozzle 21 and second suction nozzle 22 which pick up a component by negative pressure air, head main body 23 which holds first suction nozzle 21 and second suction nozzle 22, first air passage 31 causing negative pressure air supplied to flow into first suction nozzle 21, second air passage 32 causing negative pressure air supplied to flow into second suction nozzle 22, and valve device 24 which switches the states of first air passage 31 and second air passage 32 between the state in which first air passage 31 and second air passage 32 form the supply systems of negative pressure air (first supply system Cs1, second supply system Cs2) which differ from each other and the state in which first air passage 31 and second air passage 32 form single same supply system CsU.

With the configuration described above, first air passage 31 causing negative pressure air to flow into first suction nozzle 21 and second air passage 32 causing negative pressure air to flow into second suction nozzle 22 are switched between the state in which first air passage 31 and second air passage 32 form the different supply systems of negative pressure air (first supply system Cs1, second supply system Cs2) and the state in which first air passage 31 and second air passage 32 form single same supply system CsU by valve device 24. Consequently, in the event that a leakage of negative pressure air occurs in one of the suction nozzles, a risk of the suction force of the other suction nozzle being affected can be reduced as a result of different first supply system Cs1 and second supply system Cs2 being formed. As a result, the accuracy of a mounting process can be maintained.

### 5. Variation of Embodiment

In the embodiment, mounting head 20 is described as including the two suction nozzles (first suction nozzle 21, second suction nozzle 22). In contrast with this, mounting head 20 may include three or more suction nozzles. In this configuration, multiple air passages for supplying negative pressure to the three or more suction nozzles may be connected individually with the same number of supply passages 1 provided in moving table 132 in a one-to-one fashion. In addition, a configuration may be adopted in which three or more air passages are divided into two or more groups, and the grouped air passages are connected individually with the same number of supply passages formed in moving table 132 in a one-to-one fashion. As this occurs, multiple air passages are caused to communicate with each other in the same group.

With this configuration, the supply system of negative pressure air is formed for each of the three or more air passages or each of the multiple groups. As a result, compared with a configuration in which negative pressure air is supplied to three or more suction nozzles from an air passage which is branched inside head main body 23, a risk of a leakage of negative pressure air occurring in one suction nozzle affecting the other suction nozzles can be reduced.

Further, in the configuration in which mounting head 20 includes three or more suction nozzles, multiple supply passages may be coupled individually to the same number of air supply sources as that of suction nozzles, as in the case with, for example, the first mode and third mode of air supply circuit. Furthermore, in the configuration in which mounting head 20 includes three or more suction nozzles, as in the case with, for example, the second mode of air supply circuit, the number of air pressure accumulation chambers Sn and the volume thereof may be set as required based on the number of suction nozzles and the number of groups. With this configuration, too, the same working effect as that of the embodiment can be provided.

### Reference Signs List

10: Component mounter, 132: Moving table, 20: Mounting head, 21: First suction nozzle, 22: Second suction nozzle, 23: Head main body, 24: Valve device, 31: First air passage, 32: Second air passage, 51: First supply passage, 52: Second supply passage, 55: First connecting section, 56: Second connecting section, 81: First air supply source, 82: Second air supply source, Sn: Pressure accumulation chamber, Cs1: First supply system, Cs2: Second supply system, CsU: Supply system

## Claims

1. A mounting head comprising:
a first suction nozzle and a second suction nozzle which are configured to pick up a component by negative pressure air;
a head main body detachably attached to a moving table of a component mounter and configured to hold the first suction nozzle and the second suction nozzle;
a first air passage configured to communicate with a first supply passage provided in the moving table with the head main body attached to the moving table, and cause negative pressure air supplied via the first supply passage to flow into the first suction nozzle; and
a second air passage configured to communicate with a second supply passage provided in the moving table with the head main body attached to the moving table, and cause negative pressure air supplied via the second supply passage to flow into the second suction nozzle.

2. The mounting head of claim 1,
wherein the first air passage and the second air passage form negative pressure air supply systems which differ from each other by being coupled to different air supply sources via the first supply passage and the second supply passage, respectively.

3. The mounting head according to claim 1, wherein the first supply passage and the second supply passage communicate with each other outside the head main body and are coupled to a single same air supply source, and
wherein the first air passage and the second air passage form individually supply systems of negative pressure air which differ from each other when an overall volume into which volumes of the first air passage, the second air passage, the first supply passage, and the second supply passage are integrated is secured to a predetermined value or more.

4. A mounting head comprising:
a first suction nozzle and a second suction nozzle which are configured to pick up a component by negative pressure air;
a head main body configured to hold the first suction nozzle and the second suction nozzle;
a first air passage configured to cause negative pressure air supplied thereto to flow into the first suction nozzle;
a second air passage configured to cause negative pressure air supplied thereto to flow into the second suction nozzle; and
a valve device configured to switch states of first air passage and the second air passage between a state in which the first air passage and the second air passage form negative pressure air supply systems which differ from each other and a state in which the first air passage and the second air passage form a same negative pressure air supply system.

5. The mounting head according to claim 4,
wherein a head main body is detachably attached to a moving table of a component mounter,
wherein the first air passage communicates with a first supply passage provided in the moving table with the head main body attached to the moving table and causes negative pressure air supplied via the first supply passage to flow into the first suction nozzle;
a second air passage communicates with a second supply passage provided in the moving table with the head main body attached to the moving table and causes negative pressure air supplied via the second supply passage to flow into the second suction nozzle, and
wherein the valve device provides a state in which the same supply system is formed by causing the first air passage and the second air passage to communicate with each other and provides a state in which the different supply systems are formed by cutting off a communication between the first air passage and the second air passage.

6. The mounting head according to claim 4 or 5,
wherein in the event that a leakage of negative pressure air supplied to the first suction nozzle or the second suction nozzle is detected, the valve device executes the switching of states of the first air passage and the second air passage.
